# EUROPEAN PATENT SPECIFICATION

(11) **EP 2 919 282 B1**
(45) Date of publication and mention of the grant of the patent: **19.06.2019**
(21) Application number: 14180012.8
(22) Date of filing: 06.08.2014
(51) Int. Cl.: H01L 33/06, H01L 33/14, H01L 33/32

(54) **Nitride semiconductor stacked body and semiconductor light emitting device comprising the same**
Gestapelter Nitridhalbleiterkörper und eine diesen enthaltende lichtemittierende Halbleitervorrichtung
Empilement monolithique de semi-conducteurs nitrures et dispositif électroluminescent semi-conducteur comprenant celui-ci

(30) Priority: 10.03.2014 JP 2014045977; 22.07.2014 JP 2014148507
(43) Date of publication of application: 16.09.2015
(73) Proprietor: Samsung Electronics Co., Ltd., Suwon-si, Gyeonggi-do 16677 (KR)
(72) Inventor: Furuyama, Hideto, Tokyo, 105-8001 (JP); Kimura, Shigeya, Tokyo, 105-8001 (JP)
(74) Representative: Kuhnen & Wacker Patent- und Rechtsanwaltsbüro PartG mbB

(56) References cited:
- EP-A2- 2 408 028
- US-A1- 2001 030 317
- US-A1- 2006 118 820
- US-A1- 2007 272 936
- US-A1- 2012 145 993
- US-A1- 2013 056 785

## Description

### BACKGROUND

In recent years, the use of light emitting devices with a nitride semiconductor have been spread, and research and development for improving luminous efficiency have been made continuously.

### BRIEF DESCRIPTION OF THE DRAWINGS

FIG. 1 is a schematic cross-sectional view of a nitride semiconductor stacked body of a first embodiment;
FIGS. 2A and 2B are schematic energy band diagrams of the nitride semiconductor stacked body of the first embodiment;
FIG. 3 is a schematic cross-sectional view of a nitride semiconductor stacked body of a second embodiment;
FIGS. 4A and 4B are schematic energy band diagrams of the nitride semiconductor stacked body of the second embodiment;
FIG. 5 is a schematic cross-sectional view of a nitride semiconductor stacked body of a third embodiment;
FIGS. 6A and 6B are schematic energy band diagrams of the nitride semiconductor stacked body of the third embodiment;
FIG. 7 is a schematic cross-sectional view of a nitride semiconductor stacked body of a fourth embodiment;
FIGS. 8A and 8B are schematic energy band diagrams of the nitride semiconductor stacked body of the fourth embodiment;
FIGS. 9A and 9B are energy band diagrams obtained by simulating the nitride semiconductor stacked body of the first embodiment;
FIG. 10A is a carrier distribution chart in a thermal equilibrium state obtained by simulating the nitride semiconductor stacked body of the first embodiment, and FIG. 10B is an electric field intensity chart in a thermal equilibrium state obtained by simulating the nitride semiconductor stacked body of the first embodiment;
FIGS. 11A and 11B are energy band diagrams obtained by simulating the nitride semiconductor stacked body of the second embodiment;
FIGS. 12A and 12B are energy band diagrams obtained by simulating the nitride semiconductor stacked body of the fourth embodiment;
FIGS. 13A and 13B are energy band diagrams obtained by simulating a nitride semiconductor stacked body of a reference example;
FIG. 14 is a graph showing a relationship between a thickness of an AIGaN layer and an electron tunnel probability;
FIGS. 15A and 15B are schematic energy band diagrams of the nitride semiconductor stacked body of the reference example;
FIG. 16 is a schematic cross-sectional view of a semiconductor light emitting device of embodiments;
FIG. 17A is a schematic cross-sectional view of a nitride semiconductor stacked body of a fifth embodiment; and
FIG. 17B is schematic energy band diagram of the nitride semiconductor stacked body of the fifth embodiment.

In US 2006/118820 A1 an improved nitride-based light emitting heterostructure is provided. The nitride-based light emitting heterostructure includes an electron supply layer and a hole supply layer with a light generating structure disposed there between. The light generating structure includes a set of barrier layers, each of which has a graded composition and a set of quantum wells, each of which adjoins at least one barrier layer. Additional features, such as a thickness of each quantum well, can be selected/incorporated into the heterostructure to improve one or more of its characteristics. Further, one or more additional layers that include a graded composition can be included in the heterostructure outside of the light generating structure. The graded composition layer(s) cause electrons to lose energy prior to entering a quantum well in the light generating structure, which enables the electrons to recombine with holes more efficiently in the quantum well.

US 2013/056785 A1 teaches a light emitting device including a first and second section with semiconductor layers. The first section includes a first semiconductor layer doped with a first dopant, a second semiconductor layer doped with a second dopant, and a first active layer between the first and second semiconductor layers, and the second section includes a third semiconductor layer disposed on the first section, and the third semiconductor layer having an exposed region, a fourth semiconductor layer disposed on the third semiconductor layer except for the exposed region, and a second active layer between the third and fourth semiconductor layers, a first electrode disposed on the first semiconductor layer, a second electrode disposed on the fourth semiconductor layer and a third electrode inserted into a hole in the exposed region and disposed on the exposed region and the second semiconductor layer, the third electrode electrically connected to the second and third semiconductor layers.

US 2007/272936 A1 discloses a nitride based light emitting device capable of improving light emitting efficiency and reliability thereof. The nitride based light emitting device includes a first conductive semiconductor layer connected to a first electrode, a second conductive semiconductor layer connected to a second electrode, an active layer located between the first conductive semiconductor layer and the second conductive semiconductor layer and having a quantum well structure, a first insertion layer located in at least one of a boundary between the first conductive semiconductor layer and the active layer and a boundary between the second conductive semiconductor layer and the active layer, and a second insertion layer located adjacent to the first insertion.

### DETAILED DESCRIPTION

According to the embodiments according to the invention, a nitride semiconductor stacked body includes all features of claim 1. Further preferred embodiments are defined in the dependent claims.

Hereinafter, with reference to the drawings, embodiments describing certain aspects of the invention will be described. In addition, the same constituent elements are given the same reference numerals throughout the drawings.

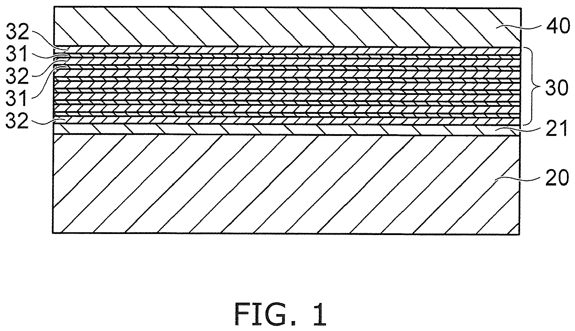

FIG. 1 is a schematic cross-sectional view of a nitride semiconductor stacked body of a first embodiment.

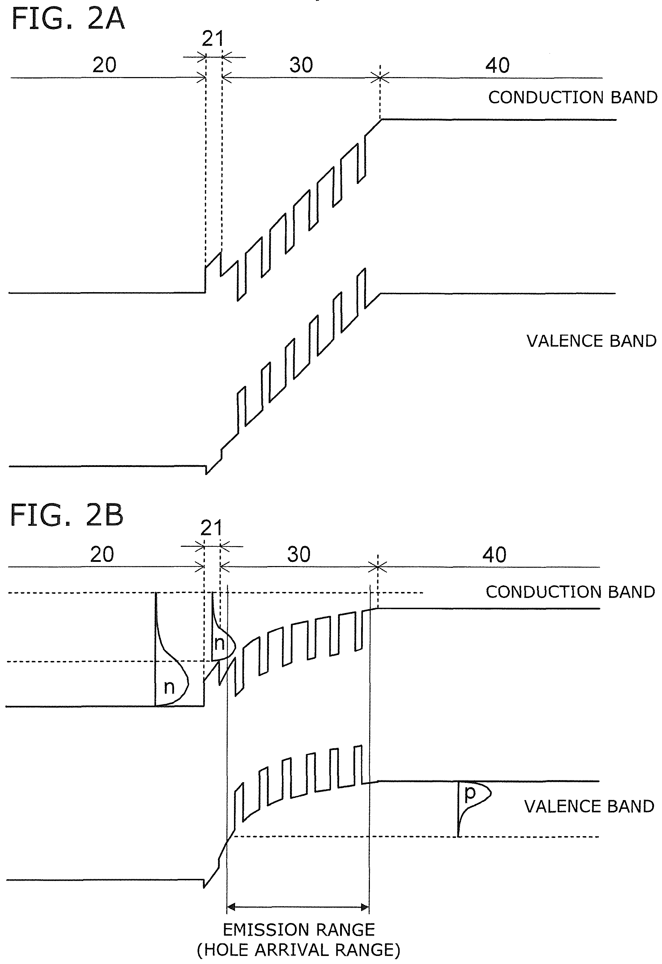

FIGS. 2A and 2B are schematic energy band diagrams of the nitride semiconductor stacked body of the first embodiment. FIG. 2A shows a thermal equilibrium state (in which a bias voltage is 0 V), and FIG. 2B shows a forward biased state. In addition, FIG. 2B also shows an energy distribution n of electron density and an energy distribution p of hole density.

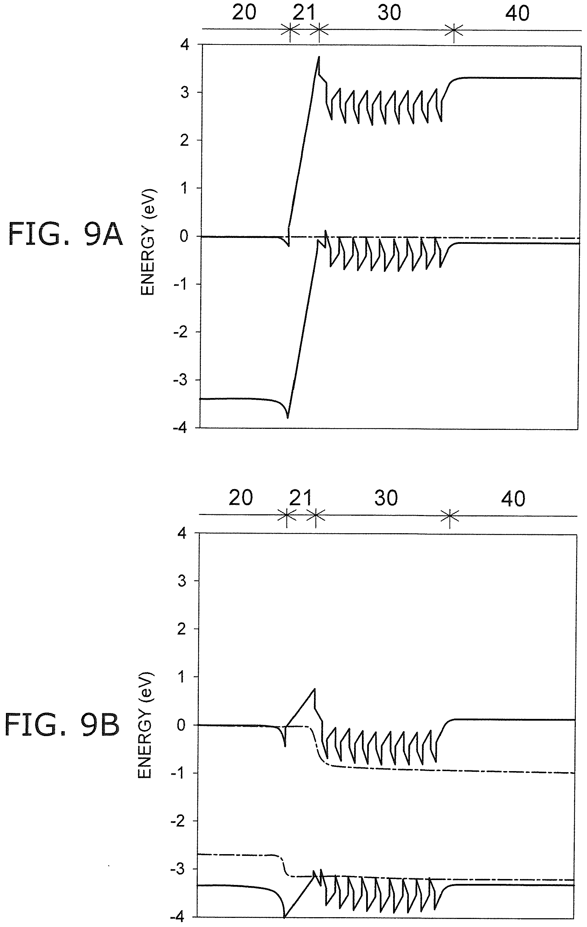

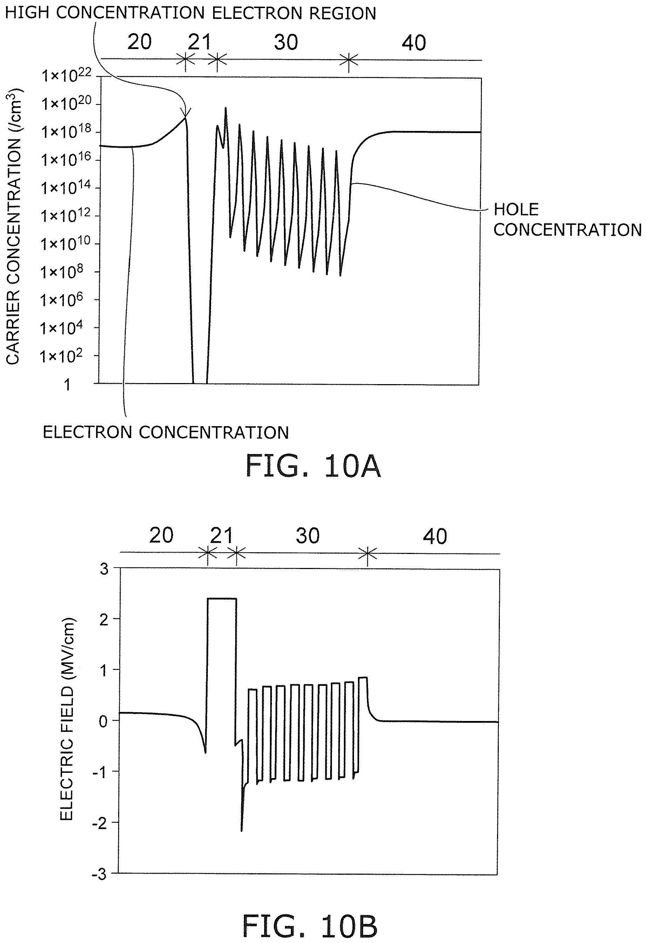

FIGS. 9A and 9B are energy band diagrams obtained by simulating the nitride semiconductor stacked body of the first embodiment. FIG. 9A shows a thermal equilibrium state (in which a bias voltage is 0 V), and FIG. 9B shows a forward biased state. In addition, FIG. 9A shows a Fermi level, and FIG. 9B shows a quasi Fermi level of electrons and a quasi Fermi level of holes with dot chain lines. Further, FIGS. 10A and 10B respectively show a carrier distribution and an electric field intensity in a thermal equilibrium state, obtained by simulating the nitride semiconductor stacked body of the first embodiment.

In addition, in the specification, the nitride semiconductor is indicated by InₓAl_{y}Ga_{1-x-y}N (0≤x≤1, 0≤y≤1, and x+y≤1). Further, a nitride semiconductor including an impurity which is added for controlling a conductivity type is also included in the nitride semiconductor.

The nitride semiconductor stacked body (hereinafter, also simply referred to as a stacked body) of the first embodiment includes an n-type cladding layer 20, a p-type cladding layer 40, and an active layer 30 which is provided between the n-type cladding layer 20 and the p-type cladding layer 40.

The n-type cladding layer 20 is, for example, an n-type GaN layer, and supplies electrons to the active layer 30 in so-called forward biased state of a p-n junction. In addition, the p-type cladding layer 40 is, for example, a p-type GaN layer, and supplies holes to the active layer 30 in so-called forward biased state of a p-n junction.

The active layer 30 has a multiple quantum well (MQW) structure in which a plurality of well layers 31 and a plurality of barrier layers 32 are alternately stacked. In addition, the number of stacked well layers 31 and barrier layers 32 is arbitrary.

The well layer 31 has smaller band gap energy than that of the n-type cladding layer 20 and the p-type cladding layer 40. The barrier layers 32 sandwich the well layer 31 between the barrier layers 32, and have greater band gap energy than that of the well layer 31.

The well layer 31 includes, for example, undoped InₓGa₁₋ₓN (0<x<1). The barrier layer 32 includes, for example, undoped GaN, and substantially does not include In. In addition, in a case where the barrier layer 32 includes In, an In composition ratio in the barrier layer 32 is lower than an In composition ratio in the well layer 31. A peak wavelength of light emitted from the active layer 30 is, for example, 400 nm or more and 650 nm or less.

In the embodiment, the term "undoped" indicates that an impurity is not intentionally added in a crystal growth process. Conversely, the term "n-type" or "p-type" indicates that an impurity for controlling a conductivity type is intentionally doped.

Further, the stacked body of the first embodiment includes an n-side electron barrier layer 21 which is located on the n-type cladding layer 20 side when viewed from the active layer 30, and the electron barrier layer is provided at a region which is close to an end of the active layer 30 on the n-type cladding layer 20 side. For example, in the example shown in FIG. 1, the n-side electron barrier layer 21 is provided between the barrier layer 32 of the active layer 30 which is the closest to the n-type cladding layer 20, and the n-type cladding layer 20. Alternatively, the n-side electron barrier layer 21 may be provided in a region of the n-type cladding layer 20 on the active layer 30 side.

In any case, the n-side electron barrier layer 21 is provided in a region within a range of a diffusion length of electrons from the active layer 30 toward the n-type cladding layer 20 side. More specifically, the n-side electron barrier layer 21 is provided in a region within a range of an electron diffusion length from the well layer 31 or the barrier layer 32 which is the closest to the n-type cladding layer 20, toward the n-type cladding layer 20 side. The n-side electron barrier layer 21 becomes a barrier to electrons with energy which is not more than an energy barrier height of the n-side electron barrier layer 21 among electrons which are injected into the active layer 30 from the n-type cladding layer 20.

The n-side electron barrier layer 21 has greater band gap energy than that of the n-type cladding layer 20 and the barrier layer 32, and is, for example, an undoped AIGaN layer.

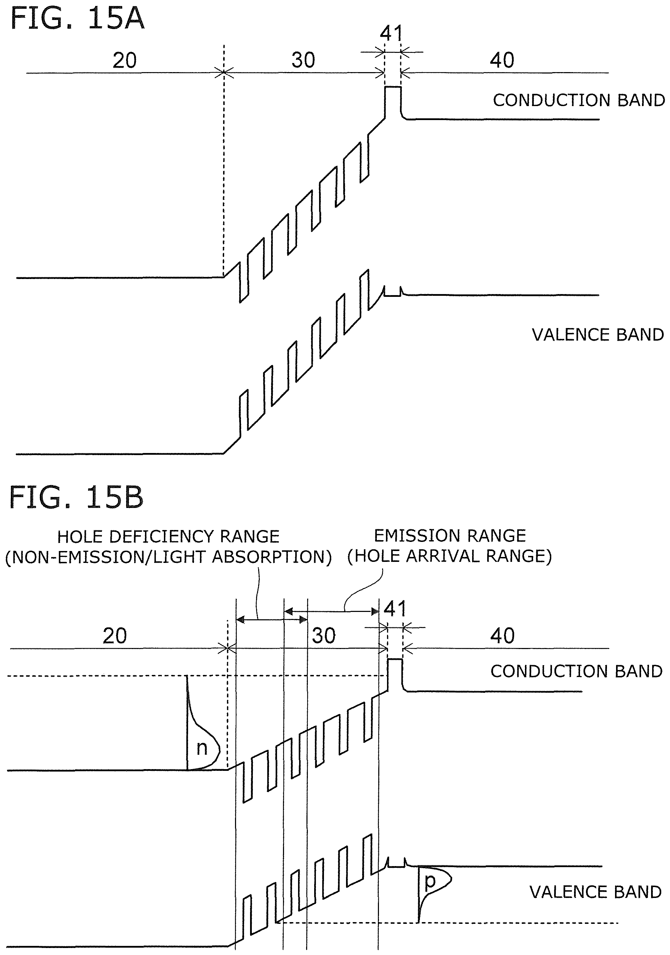

Here, FIGS. 15A and 15B are diagrams showing energy bands of a generally used nitride semiconductor stacked body as a reference example. FIG. 15A is an energy band diagram in a thermal equilibrium state (in which a bias voltage is 0 V), and FIG. 15B is an energy band diagram in a forward biased state. In addition, FIG. 15B also shows an energy distribution n of electron density and an energy distribution p of hole density.

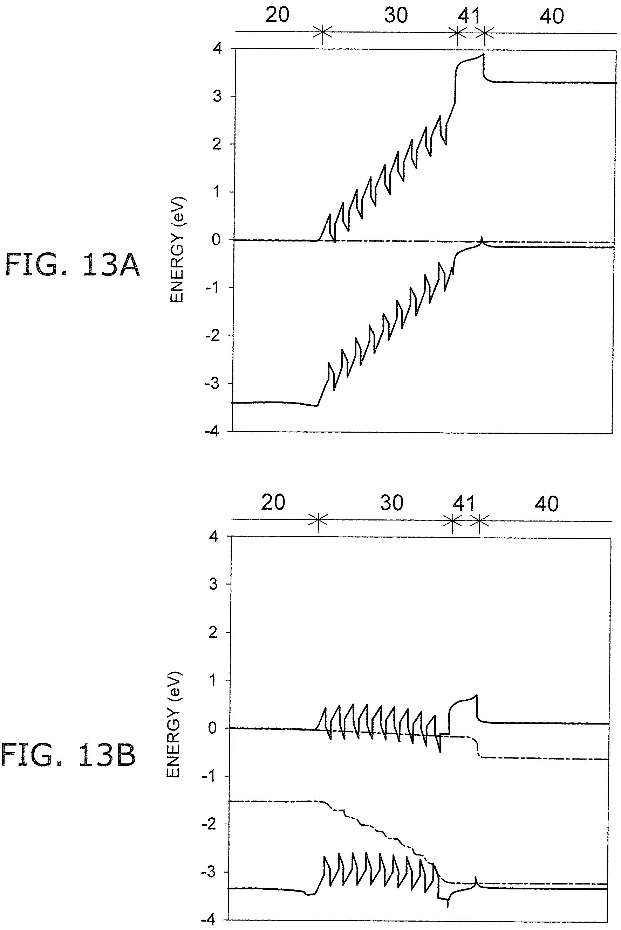

FIGS. 13A and 13B are energy band diagrams obtained by simulating the nitride semiconductor stacked body of the reference example. FIG. 13A shows a thermal equilibrium state (in which a bias voltage is 0 V), and FIG. 13B shows a forward biased state. In addition, FIG. 13A shows a Fermi level, and FIG. 13B shows a quasi Fermi level of electrons and a quasi Fermi level of holes with dot chain lines.

In the stacked body of the reference example, the n-side electron barrier layer 21 of the stacked body of the above-described first embodiment is not provided, and, instead, a p-side electron barrier layer 41 is provided between the p-type cladding layer 40 and the active layer 30. The energy band diagrams obtained by simulating the nitride semiconductor stacked body of the reference example of FIGS. 13A and 13B correspond to a configuration in which the n-side electron barrier layer 21 is omitted from the layer configuration of FIGS. 9A and 9B and the p-side electron barrier layer 41 is provided, and thus parameters of constituent elements other than the above-described constituent elements are the same as those of the simulation of FIGS. 9A and 9B.

The p-side electron barrier layer 41 has greater band gap energy than that of the p-type cladding layer 40 and the barrier layer 32, and is, for example, a p-type AIGaN layer. The p-side electron barrier layer 41 suppresses overflow of electrons from the active layer 30 to the p-type cladding layer 40 side.

In an InGaN/GaN-based multiple quantum well, since the effective mass of holes is several times greater than the effective mass of electrons (for example, in a case of GaN, the effective mass of holes is 1.7 with respect to the effective mass 0.2 of electrons) regardless of the fact that a barrier height of a conduction band (energy discontinuity at a hetero interface) is substantially equivalent to a barrier height of a valence band, there is a problem in that a considerable difference occurs between amounts of electrons and holes which can exceed the barrier layer 32 with a quantum well in a forward biased state of a p-n junction, and thus it is difficult for the holes to be injected into a quantum well of the active layer 30 (multiple quantum well) on the n-type cladding layer side.

In other words, holes injected from the p-type cladding layer 40 are unevenly distributed on the p-type cladding layer 40 side of the active layer 30, and thus the holes are deficient on the n-type cladding layer 20 side of the active layer 30. Therefore, carrier injection into the active layer 30 is uneven, and thus luminous efficiency is reduced. This can also be confirmed from the fact that the hole quasi Fermi level of the reference example of FIG. 13B is reduced on the n-type cladding layer 20 side (the level of the holes is reduced and becomes close to the center of the band gap). In this case, a quantum well close to the n-type cladding layer 20 side is in a hole exhaustion state in which holes do not nearly exist. In addition, the quantum well 31 in which carrier injection is insufficient has a low optical gain (light emission due to carrier recombination), and thus functions as a light absorption body which absorbs light emitted by other quantum wells so as to generate carriers (electrons and holes). Therefore, carrier losses (reduction in luminous efficiency) occur as a whole as long as the carriers generated due to the light absorption are not recombined without any loss. In the nitride semiconductor stacked body of the reference example, as a result of holes concentrating on a quantum well of the p-type cladding layer 40 side, the charge neutrality rule is maintained, and thus electrons are drawn onto the p-type cladding layer 40 side and electron diffusion to the p-type cladding layer 40 is prevented by the p-side electron barrier layer 41. Therefore, electrons excessively concentrate on the barrier layer 32 part of the active layer 30 which is in contact with the p-side electron barrier layer 41, and thus a carrier loss which promotes an Auger effect (non-emission carrier recombination) at the barrier layer 32 is easily caused. Originally, the Auger effect is an effect which is proportional to the cube of a carrier density, and thus a configuration in which an electron concentrating part is not formed is necessary. In addition, as a result of electrons excessively concentrating on the barrier layer 32 part which is in contact with the p-side electron barrier layer 41, the band of the p-side electron barrier layer 41 varies (subduction toward a valence band side), and an electron barrier effect of the p-side electron barrier layer 41 is reduced. Therefore, electrons are easily overflowed.

In light of these problems, according to the first embodiment, the n-side electron barrier layer 21 is provided at the region which is close to the end of the active layer 30 on the n-type cladding layer 20 side. The n-side electron barrier layer 21 is an AIGaN layer which has greater band gap energy than that of, for example, the n-type cladding layer 20 which is a GaN layer, and has an electron hetero barrier with respect to the n-type cladding layer 20. In other words, the n-side electron barrier layer 21 serves as a barrier for electrons in the n-type cladding layer 20, and prevents electrons having energy lower than conduction band hetero barriers of AIGaN and GaN among electrons of the n-type cladding layer 20 from being injected into the active layer 30. This is also the same for a case where forward bias of a p-n junction is applied between the n-type cladding layer 20 and the p-type cladding layer 40 and a current flows therebetween.

As a result, in a case where forward bias is applied to the p-n junction, electrons are accumulated on the n-type cladding layer 20 side (in the vicinity of the interface between the n-type cladding layer 20 and the n-side electron barrier layer 21) rather than the active layer 30, and holes corresponding to an amount of the accumulated electrons are injected into the active layer 30 from the p-type cladding layer 40 since the charge neutrality rule is maintained, so that the holes are drawn onto the n-type cladding layer 20 side. For this reason, the holes are supplied to the quantum well of the active layer 30 (multiple quantum well) on the n-type cladding layer 20 side so that a distribution of carriers injected into the active layer 30 is uniformized, and thus luminous efficiency can be improved.

In addition, due to a difference in electron affinity of the n-side electron barrier layer 21 and the n-type cladding layer 20, electrons are moved from the n-side electron barrier layer 21 to the n-type cladding layer 20 in a thermal equilibrium state so that the n-side electron barrier layer 21 is depleted, and thus a high electron concentration region is formed at an interface between the n-side electron barrier layer 21 and the n-type cladding layer 20. If an electron barrier (conduction band hetero barrier) of the n-side electron barrier layer 21 and the n-type cladding layer 20 increases to an extent, a quantum level is formed at a band variation part around the interface between the n-type cladding layer 20 and the n-side electron barrier layer 21 so as to draw electrons of the n-side electron barrier layer 21 and the n-type cladding layer 20, and thus a two-dimensional electron gas is generated.

For this reason, in the thermal equilibrium state, remaining electrons of the n-side electron barrier layer 21 and the active layer 30 are absorbed by the high electron concentration region or the two-dimensional electron gas, and thus depletion (exhaustion of electrons) easily occurs. As an effect of the electron affinity, a piezoelectric effect of the InₓAl_{y}Ga_{1-x-y}N (0≤x≤1, 0≤y≤1, and x+y≤1) nitride semiconductor increases, that is, the n-side electron barrier layer 21 is depleted nearly up to an intrinsic region, and thus a piezoelectric effect of the n-side electron barrier layer 21 increases (an electric field shielding effect due to remaining carriers disappears). Therefore, as shown in FIG. 9A, a great potential difference is caused at both ends of the n-side electron barrier layer 21 so that electrons of the active layer 30 are exhausted (ejected to the n-type cladding layer 20 side), and, further, holes are drawn from the p-type cladding layer 40 by negative charge of the high electron concentration region (or the two-dimensional electron gas), and thus the active layer 30 can be produced as a pseudo-p-region without intentionally doping a p-type impurity (for example, Mg or the like) in the active layer 30 and the n-side electron barrier layer 21, that is, in an undoped state. Although Mg which is thermally diffused from the p-type cladding layer 40 or the like is slightly included in an actual crystal growth layer, the pseudo-p-region indicates that a substantial p-region can be produced without including such an unintentional impurity. As a result, the n-side electron barrier layer 21 is used as a pseudo-p-n junction region, and a diffusion potential of the p-n junction is made to concentrate on the n-side electron barrier layer 21 part, and thus a maximum electric field region due to the diffusion potential of the p-n junction can be located further toward the n-type cladding layer 20 side than the central part of the active layer 30. Here, the maximum electric field region due to the diffusion potential of the p-n junction is assumed to indicate a maximum region of an electric field (a part where a gradient of an energy band is the maximum) which is generated by the diffusion potential of the p-n junction except for a local electric field which is generated at the hetero junction interface or the like even if there is no p-n junction.

FIG. 9A shows a band structure in a case where the above configuration is employed. FIG. 9A shows a simulation result including a piezoelectric effect of each nitride semiconductor unlike in the schematic band structure of FIG. 2A (for simplicity, a piezoelectric electric field effect of the nitride semiconductor is not shown). As shown in FIGS. 9A and 10B, it can be seen that a considerably great electric field due to the diffusion potential of the p-n junction concentrates on the region of the n-side electron barrier layer 21, and thus the active layer 30 (both of the quantum well 31 and the barrier layer 32) becomes a substantial p-region. Of course, in the above-described simulation, a band structure of an ideal crystal growth layer is simulated in which a p-type impurity is made not to be included in the active layer 30 at all, and a p-type impurity of the p-type cladding layer 40 or the like is not diffused or mixed into the active layer 30. In addition, in the simulation, electron concentration of 1×10¹⁶ cm⁻³ is set as an initial value in consideration of remaining carriers at an actual crystal growth layer. In other words, the active layer 30 is initially set as an n-type layer of 1×10¹⁶ cm⁻³ but is produced as a p-region due to a structural effect. As shown in FIG. 10A, this can be from the fact that the active layer 30 is filled with holes even in the thermal equilibrium state. It can also be seen that, due to an effect of the pseudo-p-region, an electric field generated by the diffusion potential of the p-n junction in the active layer 30 is considerably reduced as compared with the reference example shown in FIG. 13A.

As mentioned above, in a configuration example for locating a maximum electric field region due to the p-n junction further toward the n-type cladding layer 20 side than the active layer 30, for example, the n-type cladding layer 20 is formed of GaN (for example, carrier concentration of 1×10¹⁹ cm⁻³), the n-side electron barrier layer 21 is formed of Al_{0.25}Ga_{0.75}N (for example, undoped) with a thickness of 15 nm, and the active layer 30 (a barrier layer of GaN, and a well layer of InGaN) is entirely undoped. FIG. 9A shows a simulation result in this condition, and as a condition for producing the active layer 30 as a pseudo-p-region, preferably, an Al composition of the n-side electron barrier layer 21 is 0.05 or more, and a thickness thereof is 2 nm or more, in a case where the n-type cladding layer 20 is formed of GaN (for example, carrier concentration of 1×10¹⁹ cm⁻³), and the active layer 30 (a barrier layer of GaN, and a well layer of InGaN) are entirely undoped.

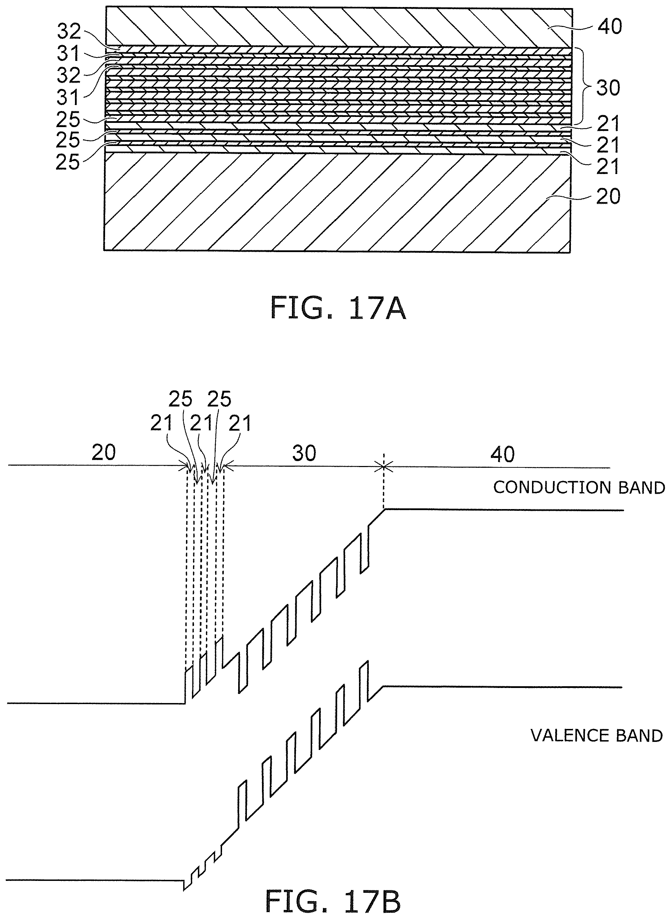

FIG. 17A is a schematic cross-sectional view of a nitride semiconductor stacked body of a fifth embodiment.

FIG. 17B is schematic energy band diagram of the nitride semiconductor stacked body of the fifth embodiment.

The n-side electron barrier layer may not be a single AIGaN layer. According to the embodiment shown in FIGS. 17A and 17B, the n-side electron barrier layers include a plurality of undoped AIGaN layers 21 and a plurality of undoped GaN layers 25 for a stress control of a crystal growth layer.

The n-side electron barrier layers include, for example, three Al_{0.25}Ga_{0.75}N layers 21. Each of the Al_{0.25}Ga_{0.75}N layers is 5nm thick for example. The GaN layer 25 is provided between the AIGaN layers 21. Each of the GaN layer 25 is 5nm thick for example. In order to produce the above-described band structure, a remaining carrier density (electron density) of the active layer 30 and the n-side electron barrier layer 21 in an undoped state is preferably, for example, 1×10¹⁶ cm⁻³ or less.

The n-side electron barrier layer 21 is provided, and, thus, in a thermal equilibrium state, a depletion layer of the p-n junction is more easily grown on a p-side than an n-side where electrons are accumulated by the n-side electron barrier layer 21 and thus a high carrier density is caused. In addition, as shown in FIG. 9B, in a forward biased state, holes are drawn in order to neutralize accumulated electron charge (n⁺⁺) at the interface between the n-type cladding layer 20 and the n-side electron barrier layer 21, and thus the holes are easily injected into the region (quantum well) of the active layer 30 on the n-type cladding layer 20 side. The depletion layer which has grown asymmetrically toward the p-side in the thermal equilibrium state is reduced from the p-side at forward bias, and injection of holes into the active layer 30 is promoted.

As a result, injection of electrons and holes into the active layer 30 is uniformized so as to allow luminous efficiency to be increased, and since a part where electrons locally concentrate in the active layer is removed, the Auger effect rapidly decreases, and thus it is possible to reduce a droop phenomenon during high injection.

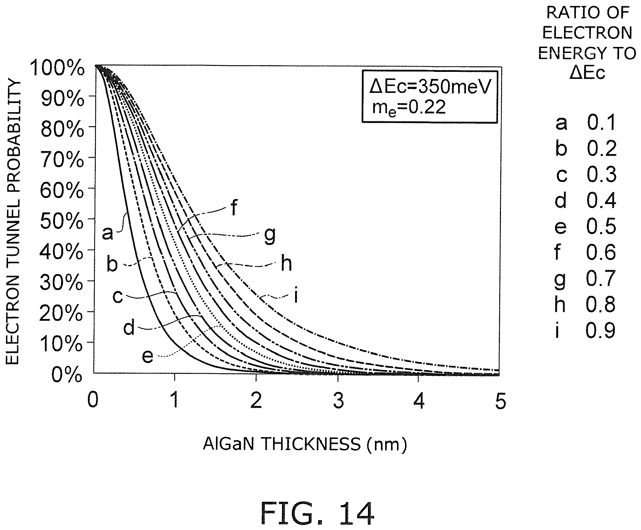

FIG. 14 is a graph showing a relationship between a thickness (nm) of an AIGaN layer interposed between a GaN layer and a GaN layer and an electron tunnel probability (%). Barrier energy ΔEc of the AIGaN layer from a bottom of a conduction band is 350 meV, and the effective mass mₑ of electrons of a GaN region is 0.22.

In addition, in the graph, a, b, c, d, e, f, g, h, and i respectively indicate electron energy of 0.1, 0.2, 0.3, 0.4, 0.5, 0.6, 0.7, 0.8, and 0.9 at the ΔEc ratio.

If the AIGaN layer which functions as the n-side electron barrier layer 21 is too thin, the layer does not serve as a barrier for electrons due to a tunnel effect. Therefore, according to the result of FIG. 14, it can be seen that a thickness of the AIGaN layer as the n-side electron barrier layer 21 is preferably 2 nm or more.

In addition, if the n-side electron barrier layer 21 is too thick, accumulated electrons at the interface between the n-type cladding layer 20 and the n-side electron barrier layer 21 are separated from the active layer 30, and thus a hole drawing effect by the accumulated electron charge is insufficient.

Therefore, a thickness of the n-side electron barrier layer 21 is preferably 2 nm or more and 50 nm or less, and, ideally, the thickness thereof is preferably 2 nm or more and 5 nm or less.

In addition, a position of the n-side electron barrier layer 21 is preferably in a range which is not more than an electron diffusion length from the active layer 30 so that electrons are injected into the active layer 30.

Further, in order to make a barrier between the n-type cladding layer 20 and the n-side electron barrier layer 21 steep, a thickness of a transition layer between the n-type cladding layer 20 and the n-side electron barrier layer 21 is preferably 2 nm or less.

Furthermore, oxygen in the AIGaN layer functions as a donor which supplies free electrons. Therefore, local oxygen concentration is increased in the n-side electron barrier layer 21 by using the AIGaN layer as the n-side electron barrier layer 21, so that accumulated electrons at the interface with the n-type cladding layer (GaN layer) 20 is increased, and carrier exhaustion of the n-side electron barrier layer 21 is effectively performed, thereby increasing the above-described hole drawing effect.

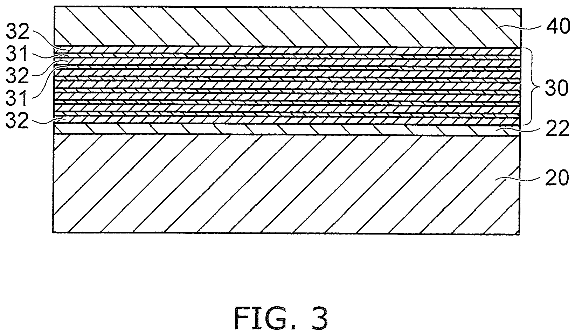

Next, FIG. 3 is a schematic cross-sectional view of a nitride semiconductor stacked body of a second embodiment.

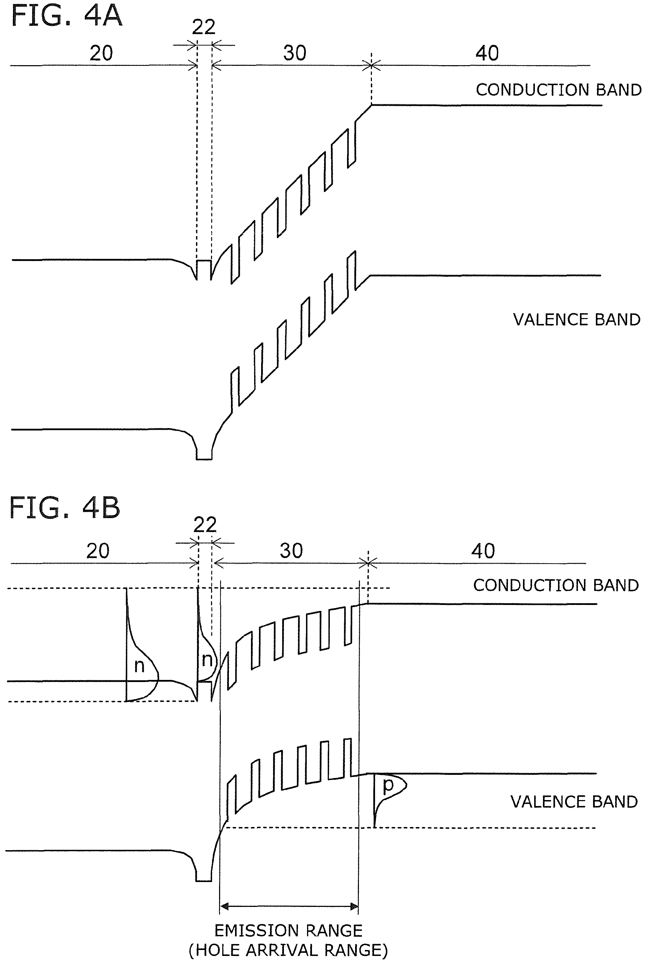

FIGS. 4A and 4B are schematic energy band diagrams of the nitride semiconductor stacked body of the second embodiment. FIG. 4A shows a thermal equilibrium state (in which a bias voltage is 0 V), and FIG. 4B shows a forward biased state. In addition, FIG. 4B also shows an energy distribution n of electron density and an energy distribution p of hole density.

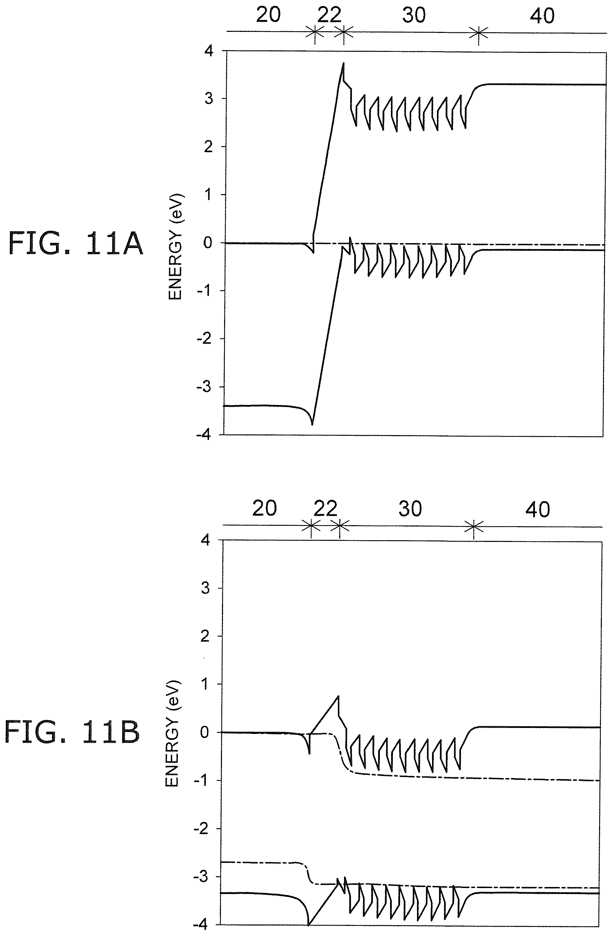

FIGS. 11A and 11B are energy band diagrams obtained by simulating the nitride semiconductor stacked body of the second embodiment. FIG. 11A shows a thermal equilibrium state (in which a bias voltage is 0 V), and FIG. 11B shows a forward biased state. In addition, FIG. 11A shows a Fermi level, and FIG. 11B shows a quasi Fermi level of electrons and a quasi Fermi level of holes with dot chain lines.

In the second embodiment, an n-type AIGaN layer which has greater band gap energy than that of the n-type cladding layer 20 and the barrier layer 32 is provided as an n-side electron barrier layer 22. Other configurations and effects are the same as those of the first embodiment.

The n-side electron barrier layer 22 is doped with, for example, Si as an n-type impurity when a film is formed. However, carriers (electrons) in the n-side electron barrier layer 22 are diffused to the n-type cladding layer 20 and the active layer 30 which have energy lower than that of the n-side electron barrier layer 22, so that the n-side electron barrier layer 22 is depleted (the carriers are exhausted) in a thermal equilibrium state, and a considerably great electric field occurs in the region of the n-side electron barrier layer 22 as shown in the simulation result of FIG. 11A due to an effect of high concentration electron storage including a two-dimensional electron gas and a piezoelectric effect. In addition, an electric field of the active layer 30 is reduced as compared with the reference example shown in FIG. 13A.

In order to produce the above-described band structure, a remaining carrier density (electron density) of the active layer 30 and the depleted (carrier exhausted) n-side electron barrier layer 22 in an undoped state is preferably, for example, 1×10¹⁶ cm⁻³ or less.

Also in the second embodiment, at forward bias, holes are drawn by the charge neutrality rule with respect to accumulated electron charge (n⁺⁺) at the interface between the n-type cladding layer 20 and the n-side electron barrier layer 22, and thus the holes are easily injected into the region of the active layer 30 on the n-type cladding layer 20 side. As a result, injection of electrons and holes into the active layer 30 is uniformized so as to allow luminous efficiency to be increased, and since a part where electrons locally concentrate in the active layer is removed, the Auger effect rapidly decreases, and thus it is possible to reduce a droop phenomenon during high injection.

In addition, in the same manner as in the first embodiment, a thickness of the n-side electron barrier layer 22 is preferably 2 nm or more and 50 nm or less, and, ideally, the thickness thereof is preferably 2 nm or more and 5 nm or less. Further, a thickness of a transition layer between the n-type cladding layer 20 and the n-side electron barrier layer 22 is preferably 2 nm or less.

Also in the second embodiment, local oxygen concentration is increased in the n-side electron barrier layer 22 by using the AIGaN layer as the n-side electron barrier layer 22, so that accumulated electrons at the interface with the n-type cladding layer (GaN layer) 20 is increased, and carrier exhaustion of the n-side electron barrier layer 22 is effectively performed, thereby increasing the above-described hole drawing effect.

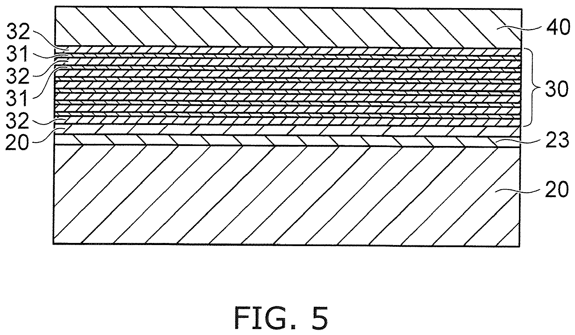

Next, FIG. 5 is a schematic cross-sectional view of a nitride semiconductor stacked body of a third embodiment.

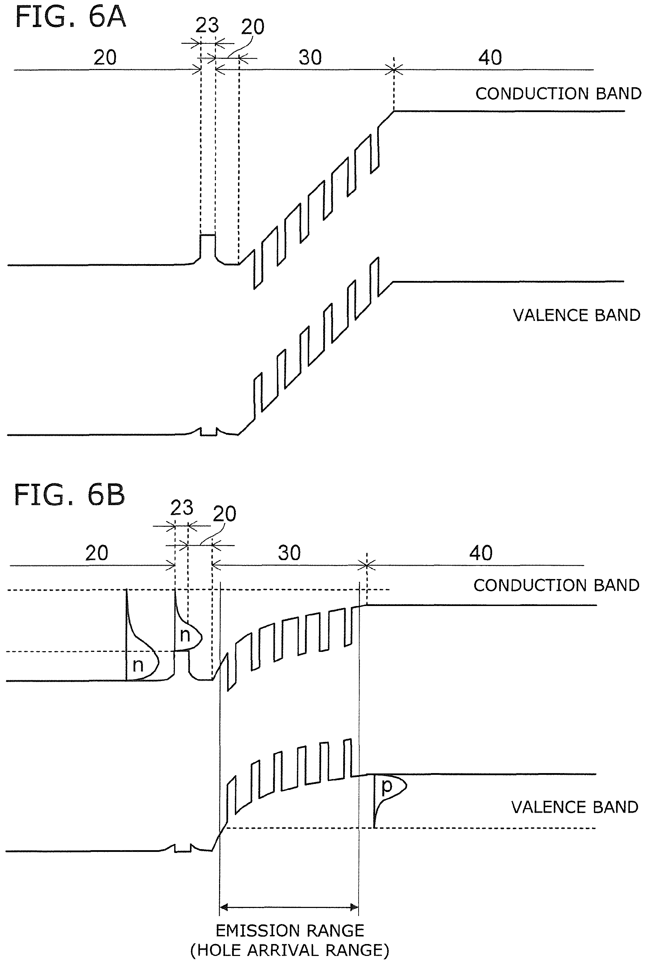

FIGS. 6A and 6B are schematic energy band diagrams of the nitride semiconductor stacked body of the third embodiment. FIG. 6A shows a thermal equilibrium state (in which a bias voltage is 0 V), and FIG. 6B shows a forward biased state. In addition, FIG. 6B also shows an energy distribution n of electron density and an energy distribution p of hole density.

In the third embodiment, a p-type AIGaN layer which has greater band gap energy than that of the n-type cladding layer 20 and the barrier layer 32 is provided inside the n-type cladding layer 20 as an n-side electron barrier layer 23.

The n-side electron barrier layer 23 is doped with, for example, Mg, Zn, Cd, or C as a p-type impurity when a film is formed.

In the third embodiment, since a band is configured so that the n-side electron barrier layer 23 (p-type) is inserted into the n-type cladding layer 20 and thus a valence band level is aligned, the n-side electron barrier layer 23 protrudes further toward a conduction band side than the n-type cladding layer 20 at forward bias, and serves as a barrier of electrons having low energy in this form, and thus electrons can be accumulated at the interface between the n-type cladding layer 20 and the n-side electron barrier layer 23. Therefore, holes are drawn by the charge neutrality rule with respect to accumulated electron charge (n⁺⁺) at the interface, and thus the holes are easily injected into the region of the active layer 30 on the n-type cladding layer 20 side. As a result, injection of electrons and holes into the active layer 30 is uniformized so as to allow luminous efficiency to be increased, and since a part where electrons locally concentrate in the active layer is removed, the Auger effect rapidly decreases, and thus it is possible to reduce a droop phenomenon during high injection.

In addition, in the same manner as in the first embodiment, a thickness of the n-side electron barrier layer 23 is preferably 2 nm or more and 50 nm or less, and, ideally, the thickness thereof is preferably 2 nm or more and 5 nm or less. Further, a thickness of a transition layer between the n-type cladding layer 20 and the n-side electron barrier layer 23 is preferably 2 nm or less.

In a case where magnesium (Mg) is doped as an impurity which leads AIGaN to a p-type, Mg is easily combined with H. Therefore, hydrogen concentration is locally further increased in the n-side electron barrier layer 23 which is a p-type AIGaN layer than the n-type cladding layer (GaN) 20 and the active layer (InGaN/GaN) 30 neither of which do not include the p-type impurity (Mg). This contributes to reduction in defects of the n-side electron barrier layer 23.

In addition, the n-side electron barrier layer 23 may be in contact with the active layer 30 without being interposed between the n-type cladding layers 20 in the same manner as in the first embodiment and the second embodiment. In this case, there is an effect in which the active layer 30 is lifted up by the n-side electron barrier layer 23 (p-doped) and is thus easily produced as a pseudo-p-region.

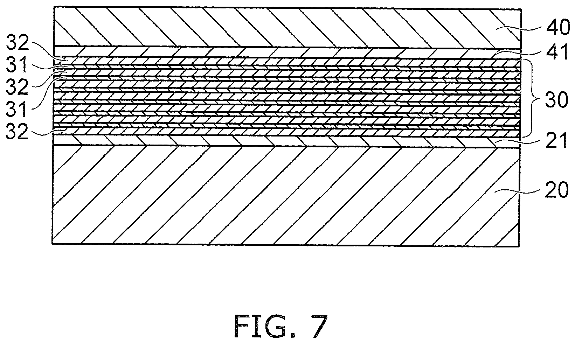

Next, FIG. 7 is a schematic cross-sectional view of a nitride semiconductor stacked body of a fourth embodiment.

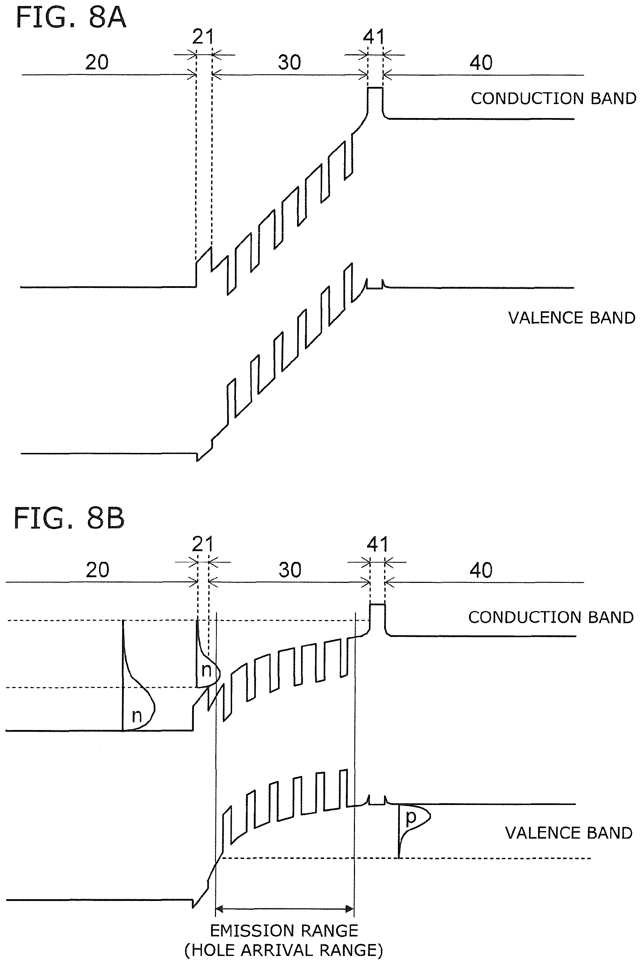

FIGS. 8A and 8B are schematic energy band diagrams of the nitride semiconductor stacked body of the fourth embodiment. FIG. 8A shows a thermal equilibrium state (in which a bias voltage is 0 V), and FIG. 8B shows a forward biased state. In addition, FIG. 8B also shows an energy distribution n of electron density and an energy distribution p of hole density.

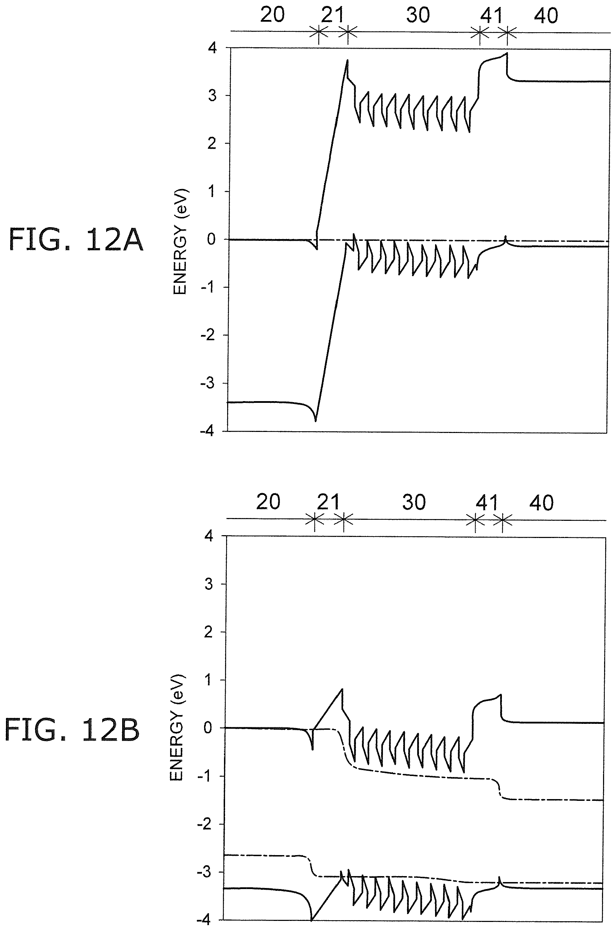

FIGS. 12A and 12B are energy band diagrams obtained by simulating the nitride semiconductor stacked body of the fourth embodiment. FIG. 12A shows a thermal equilibrium state (in which a bias voltage is 0 V), and FIG. 12B shows a forward biased state. In addition, FIG. 12A shows a Fermi level, and FIG. 12B shows a quasi Fermi level of electrons and a quasi Fermi level of holes with dot chain lines.

In the fourth embodiment, a p-side electron barrier layer 41 is further provided in addition to the configuration of the first embodiment.

The p-side electron barrier layer 41 is provided at a region which is close to an end of the active layer 30 on the p-type cladding layer 40 side. For example, in the example shown in FIG. 7, the p-side electron barrier layer 41 is provided between the barrier layer 32 of the active layer 30 which is the closest to the p-type cladding layer 40, and the p-type cladding layer 40.

The p-side electron barrier layer 41 has greater band gap energy than that of the p-type cladding layer 40 and the barrier layer 32, and is, for example, a p-type AIGaN layer.

The p-side electron barrier layer 41 prevents overflow of electrons which slightly leak from the active layer 30 to the p-type cladding layer 40 side in the first embodiment. This can also be confirmed from the fact that the electron quasi Fermi level of FIG. 12B is reduced earlier than in the p-side electron barrier layer 41 (the level of the electrons is reduced and becomes close to the center).

According to the fourth embodiment, the electron barrier layers are provided on both of the n-type cladding layer 20 side and the p-type cladding layer 40 side, and thus it is possible to increase luminous recombination efficiency of electrons and holes in the active layer 30.

In addition, also in the configurations of the second embodiment and the third embodiment, the p-side electron barrier layer 41 may be further provided on the p-type cladding layer 40 side.

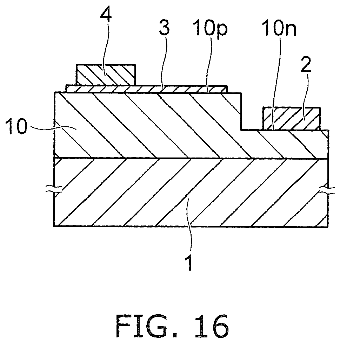

FIG. 16 is a schematic cross-sectional view of a semiconductor light emitting device according of an embodiment. FIG. 16 shows a light emitting diode (LED) as an example of the semiconductor light emitting device.

The semiconductor light emitting device of the embodiment includes a nitride semiconductor layer 10. The nitride semiconductor layer 10 includes the nitride semiconductor stacked body of any one of the above-described embodiments.

The nitride semiconductor layer 10 is formed on a substrate 1 according to a metal organic chemical vapor deposition (MOCVD) method. Alternatively, the nitride semiconductor layer 10 may be formed on the substrate 1 according to a molecular beam epitaxy (MBE) method.

As the substrate 1, for example, a silicon substrate, a sapphire substrate, an SiC substrate, a GaN substrate, or the like may be used.

In addition, the nitride semiconductor layer 10 may include not only the above-described layers (the n-type cladding layer, the active layer, the p-type cladding layer, the n-side electron barrier layer, and the p-side electron barrier layer) but also a buffer layer for reducing mismatch between lattice constants of the substrate 1 and the nitride semiconductor, a contact layer with an electrode, and the like. Further, a strained layer super lattice (SLS) buffer layer may be formed between the n-type cladding layer and the substrate 1 so that lattice defects can be reduced.

The nitride semiconductor layer 10 has a p-type layer surface 10p and an n-type layer surface 10n on an opposite side to the substrate 1. An n-side electrode pad 2 is provided on the n-type layer surface 10n. The n-side electrode pad 2 is electrically connected to the above-described n-type cladding layer 20.

A p-side electrode 3 (for example, a transparent electrode such as indium tin oxide (ITO) or an Ag electrode) is provided on the p-type layer surface 10p, and a p-side electrode pad 4 is provided on the p-side electrode 3. The p-side electrode 3 and the p-side electrode pad 4 are electrically connected to the above-described p-type cladding layer 40.

The substrate 1 may be left as it is, and may be removed. In the former case, the p-side electrode 3 is preferably a transparent electrode, and, in the latter case, light may be emitted from a surface from which the substrate is removed with the p-side electrode 3 as Ag. In addition, in the latter case, the n-side electrode may be provided on a surface from which the substrate is removed, and a transparent electrode may be formed as the n-side electrode and the n-side electrode pad 2 may be partially provided.

The light emitting diode (LED) including the nitride semiconductor stacked body of the above-described embodiments has high luminous efficiency.

In addition, the nitride semiconductor stacked body of the embodiments is not limited to an LED and is applicable to a laser diode (LD).

While certain embodiments have been described, these embodiments have been presented by way of example only, and are not intended to limit the scope of the invention. Indeed, the novel embodiments described herein may be embodied in a variety of other forms; furthermore, various omissions, substitutions and changes in the form of the embodiments described herein may be made without departing from the scope of the invention, which is defined by the appended claims only.

## Claims

1. A nitride semiconductor stacked body comprising:
an n-type cladding layer (20) including n-type GaN;
a p-type cladding layer (40) including p-type GaN;
an active layer (30) provided between the n-type cladding layer (20) and the p-type cladding layer (40), the active layer (30) including a plurality of well layers (31) including undoped InGaN, and a plurality of barrier layers (32) which are interposed between the respective well layers (31), the barrier layers (32) including undoped GaN, and having band gap energy greater than the well layers (31); and
an n-side electron barrier layer (21) provided at a region close to an end of the active layer (30) on the n-type cladding layer (20) side;
an electron concentration at an interface between the n-side electron barrier layer (21) and the n-type cladding layer (20) being higher than an electron concentration in the n-side electron barrier layer (21),
the n-side electron barrier layer (21) contacting one of the barrier layers (32) of the active layer (30),
a p-type AlGaN electron barrier layer being not provided between the active layer (30) and the p-type cladding layer (40)
**characterized in that**
the n-side electron barrier layer (21) is an oxygen containing AlGaN layer having band gap energy greater than the n-type cladding layer (20) and the barrier layer (32).

2. The nitride semiconductor stacked body according to claim 1, wherein the n-side electron barrier layer (21) is formed of a plurality of layers.

3. The nitride semiconductor stacked body according to claim 1 or 2, wherein a thickness of the n-side electron barrier layer (21) is 2 nm or more and 50 nm or less.

4. The nitride semiconductor stacked body according to claim 1, 2 or 3, wherein a thickness of a transition layer between the n-type cladding layer (20) and the n-side electron barrier layer (21) is 2 nm or less.

5. A semiconductor light emitting device comprising:
the nitride semiconductor stacked body according to claim 1, 2, 3 or 4;
an n-side electrode (2) connected to the n-type cladding layer (20); and
a p-side electrode (3, 4) connected to the p-type cladding layer (40).

## Patentansprüche

1. Gestapelter Nitridhalbleiterkörper, aufweisend:
eine n-Typ-Umhüllungsschicht (20), die ein n-Typ-GaN beinhaltet;
eine p-Typ-Umhüllungsschicht (40), die ein p-Typ-GaN beinhaltet;
eine aktive Schicht (30), die zwischen der n-Typ-Umhüllungsschicht (20) und der p-Typ-Umhüllungsschicht (40) angeordnet ist, wobei die aktive Schicht (30) eine Mehrzahl von Wannenschichten (31), die undotiertes inGaN beinhalten, und eine Mehrzahl von Barriereschichten (32) beinhaltet, die zwischen den jeweiligen Wannenschichten (31) angeordnet sind, wobei die Barriereschichten (32) undotiertes GaN beinhalten, und eine Bandlücken-Energie aufweisen, die größer ist als die der Wannenschichten (31); und
eine n-Seiten-Elektronenbarriereschicht (21), die an einem Bereich nahe einem Ende der aktiven Schicht (30) auf der Seite der n-Typ-Umhüllungsschicht (20) angeordnet ist;
eine Elektronenkonzentration an einer Schnittstelle zwischen der n-Seiten-Elektronenbarriereschicht (21) und der n-Typ-Umhüllungsschicht (20), die höher ist als eine Elektronenkonzentration in der n-Seiten-Elektronenbarriereschicht (21),
wobei die n-Seiten-Barriereschicht (21) eine von den Barriereschichten (32) der aktiven Schicht (30) kontaktiert,
eine p-Typ-AlGaN-Elektronen-Barriereschicht, die nicht zwischen der aktiven Schicht (30) und der p-Typ-Umhüllungsschicht (40) angeordnet ist,
**dadurch gekennzeichnet, dass**
die n-Seiten-Elektronenbarriereschicht (21) eine sauerstoffhaltige AlGaN-Schicht mit eine Bandlücken-Energie ist, die größer ist als die der n-Typ-Umhüllungsschicht (20) und der Barriereschicht (32).

2. Gestapelter Nitridhalbleiterkörper nach Anspruch 1, wobei die n-Seiten Elektronenbarriereschicht (21) aus einer Mehrzahl von Schichten gebildet ist.

3. Gestapelter Nitridhalbleiterkörper nach Anspruch 1 oder 2, wobei eine Dicke der n-Seiten-Elektronenbarriereschicht (21) 2 nm oder mehr und 50 nm oder weniger ist.

4. Gestapelter Nitridhalbleiterkörper nach Anspruch 1, 2, oder 3, wobei eine Dicke einer Übergangsschicht zwischen der n-Typ-Umhüllungsschicht (20) und der n-Seiten-Elektronenbarriereschicht (21) 2 nm oder weniger ist.

5. Lichtemittierende Halbleitervorrichtung, aufweisend:
einen gestapelten Nitridhalbleiterkörper nach Anspruch 1, 2, 3 oder 4;
eine n-Seiten-Elektrode (2), die mit der n-Typ-Umhüllungsschicht (20) verbunden ist; und
eine p-Seiten-Elektrode (3, 4), die mit der p-Typ-Umhüllungsschicht (40) verbunden ist.

## Revendications

1. Corps empilé à semi-conducteur de nitrure comprenant :
une couche de revêtement de type n (20) incluant du GaN de type n ;
une couche de revêtement de type p (40) incluant du GaN de type p ;
une couche active (30) prévue entre la couche de revêtement de type n (20) et la couche de revêtement de type p (40), la couche active (30) incluant une pluralité de couches de puits (31) incluant de l'InGaN non dopé, et une pluralité de couches de barrière (32) qui sont interposées entre les couches de puits (31) respectives, les couches de barrière (32) incluant du GaN non dopé, et ayant une énergie de bande interdite supérieure aux couches de puits (31) ; et
une couche de barrière aux électrons de côté n (21) prévue au niveau d'une région proche d'une extrémité de la couche active (30) sur le côté de couche de revêtement de type n (20) ;
une concentration en électrons au niveau d'une interface entre la couche de barrière aux électrons de côté n (21) et la couche de revêtement de type n (20) étant plus élevée qu'une concentration en électrons dans la couche de barrière aux électrons de côté n (21),
la couche de barrière aux électrons de côté n (21) entrant en contact avec une des couches de barrière (32) de la couche active (30),
une couche de barrière aux électrons d'AIGaN de type p n'étant pas prévue entre la couche active (30) et la couche de revêtement de type p (40)
**caractérisé en ce que**
la couche de barrière aux électrons de côté n (21) est une couche d'AIGaN contenant de l'oxygène ayant une énergie de bande interdite supérieure à la couche de revêtement de type n (20) et à la couche de barrière (32).

2. Corps empilé à semi-conducteur de nitrure selon la revendication 1, dans lequel la couche de barrière aux électrons de côté n (21) est formée d'une pluralité de couches.

3. Corps empilé à semi-conducteur de nitrure selon la revendication 1 ou 2, dans lequel une épaisseur de la couche de barrière aux électrons de côté n (21) est de 2 nm ou plus et de 50 nm ou moins.

4. Corps empilé à semi-conducteur de nitrure selon la revendication 1, 2 ou 3, dans lequel une épaisseur d'une couche de transition entre la couche de revêtement de type n (20) et la couche de barrière aux électrons de côté n (21) est de 2 nm ou moins.

5. Dispositif électroluminescent à semi-conducteur comprenant :
le corps empilé à semi-conducteur de nitrure selon la revendication 1, 2, 3 ou 4 ;
une électrode de côté n (2) connectée à la couche de revêtement de type n (20) ; et
une électrode de côté p (3, 4) connectée à la couche de revêtement de type p (40).
